# EUROPÄISCHE PATENTANMELDUNG

(11) **EP 3 691 127 A1**
(43) Veröffentlichungstag der Anmeldung: **05.08.2020**
(21) Anmeldenummer: 19154819.7
(22) Anmeldetag: 31.01.2019
(51) Int. Cl.: H03K 17/0814, H02H 3/02

(54) **SICHERER ELEKTRONISCHER SCHALTER**

(71) Anmelder: Siemens Aktiengesellschaft, 80333 München (DE)
(72) Erfinder: Köllensperger, Peter, 90425 Nürnberg (DE)

(57) **Zusammenfassung**

Die Erfindung betrifft einen elektronischen Schalter (1), aufweisend einen ersten, einen zweiten und einen dritten Anschluss (11,12,13), einen Halbleiterschalter (2), eine Sicherung (3), einen Kurzschließer (4), wobei zwischen dem ersten Anschluss (11) und dem zweiten Anschluss (12) eine Reihenschaltung von der Sicherung (3) und dem Halbleiterschalter (2) angeordnet ist und zwischen dem ersten Anschluss (11) und dem dritten Anschluss (13) eine Reihenschaltung von der Sicherung (3) und dem Kurzschließer (4) angeordnet ist. Die Erfindung betrifft weiter ein elektrisches Netz (10) mit mindestens einem derartigen elektronischen Schalter (1) und einer Energiequelle (7), wobei die Energiequelle (7) mit dem ersten Anschluss (11) und dem dritten Anschluss (13) des elektronischen Schalters (1) verbunden ist. Ferner betrifft die Erfindung ein Verfahren zum Betreiben eines derartigen elektronischen Schalters (1) oder eines derartigen elektrischen Netzes (10), wobei bei Überlastung des Halbleiterschalters (2) der Kurzschließer (4) zumindest zeitweise geschlossen wird.

## Beschreibung

Die Erfindung betrifft einen elektronischen Schalter aufweisend einen Halbleiterschalter sowie einen ersten und einen zweiten Anschluss. Die Erfindung betrifft weiter ein elektrisches Netz mit mindestens einem derartigen elektronischen Schalter und einer Energiequelle. Ferner betrifft die Erfindung ein Verfahren zum Betreiben eines derartigen elektronischen Schalters oder eines derartigen elektrischen Netzes.

Unter einem elektronischen Schalter, auch als elektronisches Schaltgerät oder als halbleiterbasiertes Schaltgerät bezeichnet, versteht man eine Komponente, die mindestens einen Halbleiterschalter aufweist und einen Strom schalten, insbesondere abschalten, kann. Beispiele für einen Halbleiterschalter sind Transistoren wie IGBTs, MOSFETS, IGCTs usw.

Halbleiterbasierte Schaltgeräte werden in der Praxis mit in Reihe geschalteten konventionellen Sicherungen ausgeführt, um bei Versagen des Halbleiterschalters noch auf eine sichere Rückfallebene zurückgreifen zu können. Die Sicherung wird so ausgelegt und dimensioniert, dass sie erst bei einem Kurzschlussstrom durch den Halbleiterschalter und einem Abschaltversagen des Halbleiterschalters auslöst. Aufgabe der Sicherung ist es, die angeschlossene Last oder das angeschlossene Teilnetz mit seinen Leitungen etc. zu schützen.

Der Erfindung liegt die Aufgabe zugrunde, einen elektronischen Schalter zu verbessern.

Diese Aufgabe wird durch einen elektronischen Schalter, aufweisend einen ersten, einen zweiten und einen dritten Anschluss, einen Halbleiterschalter, eine Sicherung und einen Kurzschließer gelöst, wobei zwischen dem ersten Anschluss und dem zweiten Anschluss eine Reihenschaltung von der Sicherung und dem Halbleiterschalter angeordnet ist und zwischen dem ersten Anschluss und dem dritten Anschluss eine Reihenschaltung von der Sicherung und dem Kurzschließer angeordnet ist. Weiter wird diese Aufgabe durch ein elektrisches Netz mit mindestens einem derartigen elektronischen Schalter und einer Energiequelle gelöst, wobei die Energiequelle mit dem ersten Anschluss und dem dritten Anschluss des elektronischen Schalters verbunden ist. Diese Aufgabe wird ferner durch ein Verfahren zum Betreiben eines derartigen elektronischen Schalters oder eines derartigen elektrischen Netzes gelöst, wobei bei Überlastung des Halbleiterschalters der Kurzschließer zumindest zeitweise geschlossen wird.

Weitere vorteilhafte Ausgestaltungen der Erfindung sind in den abhängigen Ansprüchen angegeben.

Der Erfindung liegt die Erkenntnis zugrunde, dass sich durch die Reihenschaltung von Sicherung und Kurzschließer ein Kurzschlussstrom erzeugen lässt, der zum Ansprechen der Sicherung führt und damit den Halbleiterschalter und eine am elektronischen Schalter angeschlossene Last oder mehrere dort angeschlossene Lasten vor Überlastung schützt. Dabei wird eine Energiequelle, zum Beispiel ein energiespeisender DC-Bus, an dem ersten und dritten Anschluss des elektronischen Schalters angeschlossen und die Lasten bzw. ein Teilnetz mit verschiedenen Lasten wird mit dem zweiten und dritten Anschluss verbunden.

Falls dem Halbleiterschalter eine Überlastung droht, wird der Halbleiterschalter schnellstmöglich stromlos gemacht. Dies wird dadurch erreicht, dass der Kurzschließer in den leitenden Zustand gebracht wird und einen Kurzschlussstrom über die Sicherung aus der angeschlossenen Energiequelle treibt. Als Folge löst die Sicherung aus und der Halbleiterschalter wird stromlos. Damit wird auch die Übertragung von elektrischer Energie an die an den elektronischen Schalter angeschlossenen Lasten unterbrochen und diese Lasten vor Überlastung geschützt. An den elektronischen Schalter können anstelle von mehreren Lasten auch nur eine Last, ein Verbraucher oder ein Teilnetz angeschlossen sein.

Die Gefahr bei einer Überlastung des Halbleiterschalters liegt unter anderem darin, dass er nicht mehr öffnen kann oder beim Öffnen Schaden nimmt. Durch Auslösen der Sicherung wird diese Gefahr, d.h. sowohl ein Schaltversagen als auch eine Beschädigung im Abschaltvorgang, vermieden, da der Strom durch die Sicherung abgeschaltet wird. Nach Rücksetzen oder Austausch der Sicherung ist der elektronische Schalter wieder einsatzfähig. Darüber hinaus sichert die Sicherung die daran angeschlossenen Lasten und Leitungen ebenfalls vor Überlastung.

Eine Überlastung oder eine drohende Überlastung kann mit Hilfe eines Kriteriums erkannt werden. Beispielsweise kann die Überlastung anhand eines Stromwertes durch den Halbleiterschalter oder durch Auswertung des Stromwertes ermittelt werden. Dabei ist es beispielsweise auch möglich, die Überlastung oder eine drohende Überlastung anhand einer Temperatur, insbesondere der Sperrschichttemperatur, des Halbleiters des Halbleiterschalters zu erkennen. Für die Bestimmung der Temperatur, insbesondere anhand eines Temperaturmodells, kann auch der Stromwert herangezogen werden.

Der Halbleiterschalter wird durch das beschriebene Verfahren zuverlässig vor einer Zerstörung oder Beschädigung geschützt, sodass nach Austausch oder Rücksetzen der Sicherung und gegebenenfalls nach Beseitigung des überstromverursachenden Fehlers ein Weiterbetrieb ohne Austausch des teuren Halbleiterschalters möglich ist.

Eine Beschädigung oder Zerstörung des Halbleiterschalters kann somit vielfach vermieden werden, womit wesentliche Kosteneinsparungen realisiert werden. Außerdem existiert noch eine zweite Auslösemöglichkeit für die Sicherung, sodass eine Redundanz zu dem Halbleiterschalter besteht, die ein sicheres Abschalten sicherstellt.

Ein weiterer Vorteil des elektronischen Schalters liegt in der Funktion, dass der elektronische Schalter auch im Falle einer Fehlfunktion beim Halbleiterschalter ein sicheres Öffnen des elektronischen Schalters realisieren kann. Dann kann durch Schließen des Kurzschließers und das folgende Auslösen, d.h. Öffnen, der Sicherung, der Verbraucher, die Last oder ein angeschlossenes Teilnetz, das am zweiten Anschluss des elektronischen Schalters angeschlossen ist, von der Energiequelle, die mit dem ersten Anschluss verbunden ist, getrennt werden.

Falls der Schalter im Kurzschließer eine Spannung mit unterschiedlicher Polarität sperren und einen Strom mit unterschiedlicher Polarität führen kann, was durch die Verwendung zweier Halbleiter die antiseriell oder antiparallel verschaltet sind, auf einfache Weise realisiert werden kann, so kann der Schalter sowohl für Wechselspannungsanwendungen als Wechselspannungsschalter oder auch für Gleichspannungsanwendungen mit beiden Polaritäten als Gleichspannungsschalter verwendet werden.

Der elektronische Schalter ist somit für die Verwendung als Wechselstromschalter als auch als Gleichstromschalter für unterschiedliche Polaritäten nutzbar sofern der Kurzschließer eine Spannung mit unterschiedlicher Polarität sperren und einen Strom mit unterschiedlicher Polarität führen kann.

Bei einer vorteilhaften Ausgestaltung der Erfindung ist zwischen dem zweiten Anschluss und dem dritten Anschluss ein weiterer Kurzschließer angeordnet. Falls die Last rückspeisefähig ist oder einen Energiespeicher aufweist, kann es auch zu einem Strom von der Last oder mehreren Lasten in Richtung elektronischen Schalter kommen. Durch den leitenden Kurzschließer entsteht dann ein Strom von der Last bzw. den Lasten über den Halbleiterschalter durch den Kurzschließer. Der weitere Kurzschließer dient dazu, einen Stromfluss von der Lastseite kommt, durch den Halbleiterschalter auszuschließen. Dabei wird der weitere Kurzschließer zumindest zeitweise geschlossen, wenn der Kurzschließer geschlossen wird oder geschlossen ist. Das Schließen des weiteren Kurzschließers kann somit zeitgleich erfolgen oder mit einem zeitlichen Versatz zum Schließen des Kurzschließers, um einen Stromfluss von der Energiequelle durch den Halbleiterschalter und den weiteren Kurzschließer sicher ausschließen zu können.

Somit hat es sich zum Schutz des Halbleiterschalters als vorteilhaft erwiesen, den weiteren Kurzschließer zu schließen, sofern die angeschlossene Last einen derartigen Kurzschluss zulässt, um einen Stromfluss durch den Halbleiterschalter zu vermeiden oder gar ganz auszuschließen.

Bei einer weiteren vorteilhaften Ausgestaltung der Erfindung ist der Kurzschließer als Thyristor ausgebildet. Thyristoren sind kostengünstig am Markt verfügbar und verfügen gleichzeitig über eine sehr hohe kurzzeitige Überlastfähigkeit. Diese ist wichtig, um kurzzeitig einen hohen Kurzschlussstrom führen zu können, ohne den Kurzschließer, in diesem Fall den Thyristor, zu beschädigen. Der Nachteil eines Thyristors, dass er einen Strom nicht abschalten kann, fällt nicht ins Gewicht, da das Abschalten durch die Sicherung erfolgt und somit der Strom durch den Thyristor schon nach kurzer Zeit zum Erliegen kommt.

Wird der Kurzschließer durch anti-parallel geschaltete Thyristorpärchen als Schalter gebildet, so kann ein solcher Schalter als Wechselspannungsschalter und/oder als Gleichspannungsschalter mit beiden Polaritäten eingesetzt werden.

Neben Thyristoren können auch andere schaltbare Halbleiterelemente verwendet werden, sofern diese den hohen Kurzschlussstrom tragen können und dabei die Spannung über sich selbst ausreichend klein halten.

Bei einer weiteren vorteilhaften Ausgestaltung der Erfindung ist zwischen dem Halbleiterschalter und dem zweiten Anschluss eine weitere Sicherung derart angeordnet, dass zwischen dem zweiten Anschluss und dem dritten Anschluss eine Reihenschaltung von dem weiteren Kurzschließer und der weiteren Sicherung angeordnet ist. Mit einer derartigen Ausgestaltung lassen sich zwei Teilnetze miteinander verbinden. Bei einer Überlastung des Schalters können der Kurzschließer und der weitere Kurzschließer gleichzeitig geschlossen werden, so dass die Sicherung und die weitere Sicherung auslösen und der Energieaustausch zwischen den beiden Teilnetzen unterbrochen wird. Der Halbleiterschalter unterliegt mit dem gleichzeitigen Schließen des Kurzschließers und des weiteren Kurzschließers keinem Kurzschlussstrom und wird somit nicht weiter belastet, sondern schnell in einen spannungs- und stromlosen Zustand überführt.

Darüber hinaus ist der elektronische Schalter in dieser Ausführung symmetrisch aufgebaut, so dass er vielseitig für alle Anwendungen, insbesondere für beliebige Kombinationen von Teilnetzen und elektrischen Verbrauchern geeignet ist und keine spezielle Anpassung benötigt. Zudem ist durch die beiden Sicherungen eine Redundanz vorhanden, die den elektronischen Schalter besonders sicher macht.

Bei einer weiteren vorteilhaften Ausgestaltung der Erfindung wird der weitere Kurzschließer geschlossen, wenn der Kurzschließer geschlossen ist und ein Strom durch den Halbleiterschalter einen vorgebbaren Grenzwert überschreitet oder wenn der Betrag des Stroms durch den Halbleiterschalter den vorgebbaren Grenzwert überschreitet. Da das Schließen des weiteren Kurzschließers durchaus eine Belastung für die angeschlossenen Lasten darstellen könnte, hat es sich als günstig erwiesen, diesen nur zu schließen, wenn sich wirklich eine Belastung für den Halbleiterschalter durch ein Rückspeisen der Last ergeben würde. Dabei wird die Auslösung in vorteilhafterweise von einem Strom durch den Halbleiterschalter abhängig gemacht. Überschreitet dieser gemessene Stromwert oder der Betrag des gemessenen Stromwertes oder der Effektivwert des gemessenes Stromwertes einen vorgebbaren Grenzwert, so wird der weitere Kurzschließer geschlossen sofern auch schon der Kurzschließer geschlossen ist.

Im Folgenden wird die Erfindung anhand der in den Figuren dargestellten Ausführungsbeispiele näher beschreiben und erläutert. Es zeigen
- FIG 1 und FIG 2: Ausführungsbeispiele eines elektronischen Schalters,
- FIG 3: Ausführungsbeispiel eines Kurzschließers
- FIG 4: ein elektrisches Netz und
- FIG 5 und FIG 6: Zeitverläufe von Größen des Halbleiterschalters

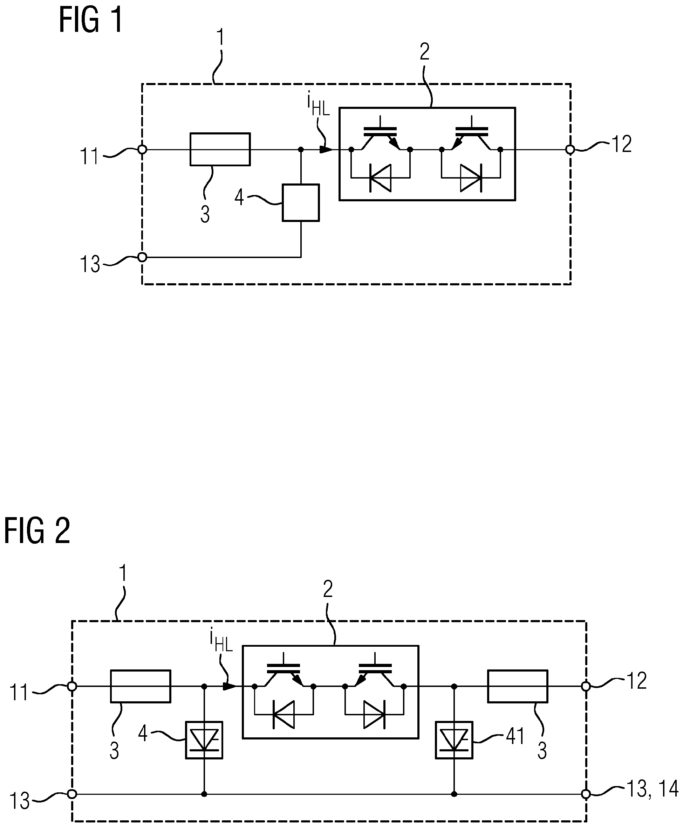

Die FIG 1 zeigt einen elektronischen Schalter 1. Der elektronische Schalter 1 weist einen ersten Anschluss 11, einen zweiten Anschluss 12 und einen dritten Anschluss 13 auf. Zwischen dem ersten Anschluss 11 und dem zweiten Anschluss 12 ist eine Reihenschaltung einer Sicherung 3 und eines Halbleiterschalters 2 angeordnet. Der Halbleiterschalter 2 weist zwei Halbleiter auf, die jeweils einen Strom unterschiedlicher Polarität abschalten können. Somit ist der elektronische Schalter 1 in der Lage, einen Strom i_{HL} durch den Halbleileiterschalter 2 unabhängig von seiner Polarität zu schalten, insbesondere abzuschalten. Zwischen dem ersten Anschluss 11 und dem dritten Anschluss 13 ist eine Reihenschaltung der Sicherung 3 und eines Kurzschließers 4 angeordnet. Dabei bilden die Komponenten Sicherung 3, Halbleiterschalter 2 und Kurzschließer 4 eine Sternschaltung. Bei dieser Sternschaltung sind diese drei Komponenten in einem Sternpunkt miteinander verbunden und darüber hinaus jeweils mit einem Anschluss des elektronischen Schalters 1 verbunden. Der erste Anschluss 11 und der dritte Anschluss 13 sind für die Verbindung mit einer hier nicht dargestellten Energiequelle 7 oder mit einem energiespeisenden DC-Bus vorgesehen. Der zweite Anschluss 12, bzw. die Spannung zwischen zweiten Anschluss 12 und drittem Anschluss 13 ist für die Verbindung mit einer Last oder einem Verbraucher vorgesehen. Ebenso ist möglich, diese Anschlüsse mit einem Teilnetz zu verbinden, das eine Vielzahl von Lasten bzw. elektrische Verbraucher aufweist.

Die FIG 2 zeigt ein weiteres Ausführungsbeispiel eines elektronischen Schalters 1. Zur Vermeidung von Wiederholungen wird auf die Beschreibung zur FIG 1 sowie auf die dort eingeführten Bezugszeichen verwiesen. Dieser elektronische Schalter 1 weist einen weiteren Kurzschließer 41 auf, der zwischen dem zweiten Anschluss 12 und dem dritten Anschluss 13 des elektronischen Schalters 1 angeordnet ist. Damit ist der weitere Kurzschließer 41 parallel zu einer Reihenschaltung aus Halbleiterschalter 2 und Kurzschließer 4 angeordnet. Zur einfachen Verbindung mit einer Quelle, insbesondere mit einer hier nicht dargestellten Energiequelle 7, und einer Last besitzt der elektronische Schalter 1 die quellenseitigen Anschlüsse, d.h. den ersten Anschluss 11 und den dritten Anschluss 13 und die lastseitigen Anschlüsse, d.h. den zweiten Anschluss 12 und einen weiteren Anschluss 14. Da der weitere Anschluss 14 fest mit dem Potential des dritten Anschlusses 13 gekoppelt ist, kann dieser weitere Anschluss 14 auch als dritter Anschluss 13 bezeichnet werden. Ebenso kann ein weiterer Anschluss 14 zur Verbindung mit einem Verbraucher oder einer Last auch außerhalb des elektronischen Schalters vorhanden sein. Es ist lediglich eine leitende Verbindung zum dritten Anschluss 13 vorzusehen.

Darüber hinaus weist dieser elektronische Schalter zwischen dem Halbleiterschalter 2 und dem zweiten Anschluss optional eine weitere Sicherung 31 auf. Mit dieser Sicherung können sowohl der erste Anschluss 11 sowie der zweite Anschluss 12 sicher elektrisch vom Halbleiterschalter 2 getrennt werden, indem bei Überlastung des Halbleiterschalters der Kurzschließer 4 sowie der weitere Kurzschließer 41 gleichzeitig geschlossen werden.

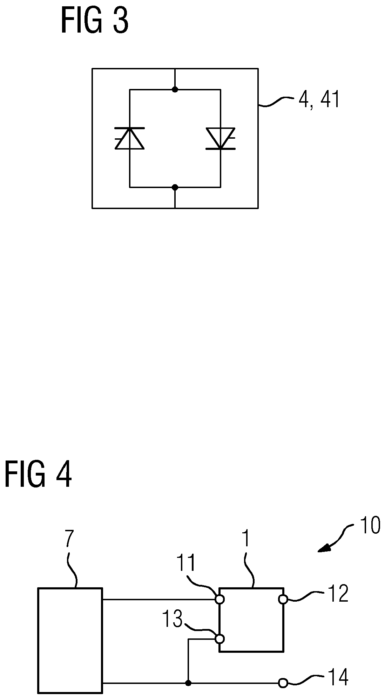

Der Kurzschließer 4 und der weitere Kurzschließer 41 sind in diesem Ausführungsbeispiel jeweils als ein Thyristor dargestellt. Wenn davon ausgegangen werden kann, dass das Potential des ersten bzw. zweiten Anschlusses 11,12 immer größer oder gleich dem Potential des dritten Anschlusses 13, so ist ein einzelner Thyristor hinreichend. Kann hingegen der dritte Anschluss auch ein höheres Potential als der erste Anschluss 11 bzw. der zweite Anschluss 12 annehmen, so verwendet man vorteilhafterweise jeweils zwei Thyristoren die antiparallel zueinander angeordnet sind. Eine solche Anordnung zeigt die FIG 3. Ein elektronischer Schalter 1 mit einem Kurzschließer 4 und/oder einem weiteren Kurzschließer 41 gemäß FIG 3 ermöglicht den Einsatz in DC Netzen, bei denen die Polarität der Gleichspannung sich ändern kann und den Einsatz in Wechselspannungsnetzen.

Die FIG 4 zeigt ein elektrisches Netz 10 mit einer Energiequelle 7 und einem elektronischen Schalter 1. Der elektronische Schalter 1 weist dabei die zuvor beschriebenen Anschlüsse 11, 12, 13 auf. Der weitere Anschluss 14 ist dabei außerhalb des elektronischen Schalters 1 angeordnet und mit dem dritten Anschluss 13 des elektronischen Schalters 1 verbunden. Der zweite Anschluss 12 und der weitere Anschluss 14 bilden die lastseitigen Anschlüsse zur Verbindung mit einem oder mehreren Verbrauchern bzw. Lasten oder einem Teilnetz.

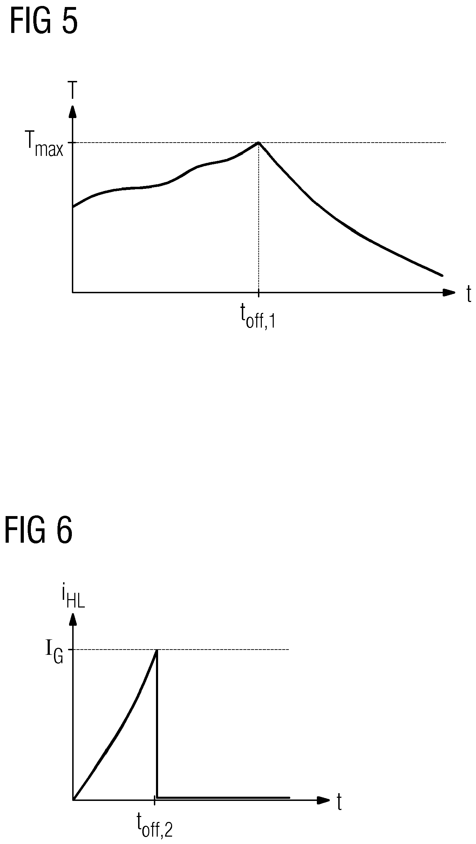

Die FIG 5 zeigt den Zeitverlauf der Temperatur T des Halbleiterschalters 2. Bei dieser Temperatur kann es sich beispielsweise um die Sperrschichttemperatur des Halbleiters handeln, die mittels eines Rechenmodells aus Messgrößen wie beispielsweise einem Temperaturwert und/oder eines Stromes bestimmt wird. Mit Hilfe der Temperatur, insbesondere der Sperrschichttemperatur, kann ein Kriterium gebildet werden, mit dem man eine Überlastung bzw. eine drohende Überlastung des Halbleiterschalters 2 erkennen kann.

In diesem Beispiel schwankt die Temperatur T, beispielsweise abhängig vom Betriebszustand und/oder der Belastung des Halbleiterschalters 2. Erreicht die Temperatur T einen vorgebbaren Grenzwert T_{Max}. wie zum Zeitpunkt t_{off,1}, dann schließt der Kurzschließer 4, um einen Kurzschlussstrom durch die Sicherung 3 zu erzeugen und die Sicherung 3 zum Auslösen zu bringen. Beim Auslösen geht die Sicherung 3 in den trennenden Zustand über. Nach dem Auslösen der Sicherung 3 fällt die Temperatur T aufgrund der nicht mehr vorliegenden Belastung durch den Stromfluss ab.

Die FIG 6 zeigt den Zeitverlauf des Betrages des Stroms i_{HL} durch den Halbleiterschalter 2. Durch das Auslösen des Kurzschließers 4 kann auch ein rückspeisender Strom der Last durch den Halbleiterschalter 2 und Kurzschließer 4 fließen. Aufgrund des Kurzschlusses steigt der Betrag dieses Stroms i_{HL} schnell an. Bei Erreichen des Grenzwert I_{G}, zum Zeitpunkt t_{off,2}, schließt der weitere Kurzschließer 41 und der rückspeisende Strom fließt nicht mehr durch den Halbleiterschalter 2 sondern durch den weiteren Kurzschließer 41.

Zusammenfassend betrifft die Erfindung einen elektronischen Schalter, aufweisend einen ersten, einen zweiten und einen dritten Anschluss, einen Halbleiterschalter, eine Sicherung, einen Kurzschließer, wobei zwischen dem ersten Anschluss und dem zweiten Anschluss eine Reihenschaltung von der Sicherung und dem Halbleiterschalter angeordnet ist und zwischen dem ersten Anschluss und dem dritten Anschluss eine Reihenschaltung von der Sicherung und dem Kurzschließer angeordnet ist. Die Erfindung betrifft weiter ein elektrisches Netz mit mindestens einem derartigen elektronischen Schalter und einer Energiequelle, wobei die Energiequelle mit dem ersten Anschluss und dem dritten Anschluss des elektronischen Schalters verbunden ist. Ferner betrifft die Erfindung ein Verfahren zum Betreiben eines derartigen elektronischen Schalters oder eines derartigen elektrischen Netzes, wobei bei Überlastung des Halbleiterschalters der Kurzschließer zumindest zeitweise geschlossen wird.

## Patentansprüche

1. Elektronischer Schalter (1), aufweisend
- einen ersten, einen zweiten und einen dritten Anschluss (11, 12, 13),
- einen Halbleiterschalter (2),
- eine Sicherung (3) und
- einen Kurzschließer (4),
wobei zwischen dem ersten Anschluss (11) und dem zweiten Anschluss (12) eine Reihenschaltung von der Sicherung (3) und dem Halbleiterschalter (2) angeordnet ist und zwischen dem ersten Anschluss (11) und dem dritten Anschluss (13) eine Reihenschaltung von der Sicherung (3) und dem Kurzschließer (4) angeordnet ist.

2. Elektronischer Schalter (1) nach Anspruch 1, wobei zwischen dem zweiten Anschluss (12) und dem dritten Anschluss (13) ein weiterer Kurzschließer (41) angeordnet ist.

3. Elektronischer Schalter (1) nach einem der Ansprüche 1 oder 2, wobei der Kurzschließer (41) als Thyristor ausgebildet ist.

4. Elektronischer Schalter (1) nach einem der Ansprüche 1 bis 3, wobei zwischen dem Halbleiterschalter (2) und dem zweiten Anschluss (12) eine weitere Sicherung (31) derart angeordnet ist, dass zwischen dem zweiten Anschluss (12) und dem dritten Anschluss (13) eine Reihenschaltung von dem weiteren Kurzschließer (41) und der weiteren Sicherung (31) angeordnet ist.

5. Elektrisches Netz (10) mit mindestens einem elektronischen Schalter (1) nach einem der Ansprüche 1 bis 4 und einer Energiequelle (7), wobei die Energiequelle (7) mit dem ersten Anschluss (11) und dem dritten Anschluss (13) des elektronischen Schalters (1) verbunden ist.

6. Verfahren zum Betreiben eines elektronischen Schalters (1) nach einem der Ansprüche 1 bis 4 oder eines elektrischen Netzes (10) nach Anspruch 5, wobei bei Überlastung des Halbleiterschalters (2) der Kurzschließer (4) zumindest zeitweise geschlossen wird.

7. Verfahren nach Anspruch 6, wobei der elektronische Schalter (1) einen weiteren Kurzschließer (41) gemäß Anspruch 2 aufweist, wobei der weitere Kurzschließer (41) zumindest zeitweise geschlossen wird, wenn der Kurzschließer (4) geschlossen wird oder geschlossen ist.

8. Verfahren nach Anspruch 7, wobei der weitere Kurzschließer (41) geschlossen wird, wenn der Kurzschließer (4) geschlossen ist und ein Strom (i_{HL}) durch den Halbleiterschalter (2) einen vorgebbaren Grenzwert (I_{G}) überschreitet oder wenn der Betrag des Stroms (i_{HL}) durch den Halbleiterschalter (2) den vorgebbaren Grenzwert (I_{G}) überschreitet.
